# EUROPEAN PATENT SPECIFICATION

(11) **EP 3 367 521 B1**
(45) Date of publication and mention of the grant of the patent: **03.03.2021**
(21) Application number: 16865635.3
(22) Date of filing: 13.10.2016
(51) Int. Cl.: H02B 1/20, H05K 7/14

(54) **OUTPUT POWER DISTRIBUTION MODULE AND DISTRIBUTION CABINET**
AUSGANGSLEISTUNGSVERTEILUNGSMODUL UND VERTEILERSCHRANK
MODULE DE DISTRIBUTION DE PUISSANCE DE SORTIE ET ARMOIRE DE DISTRIBUTION

(30) Priority: 19.11.2015 CN 201510812417
(43) Date of publication of application: 29.08.2018
(73) Proprietor: Huawei Technologies Co., Ltd., Longgang District Shenzhen, Guangdong 518129 (CN)
(72) Inventor: SONG, Qingfei, Shenzhen Guangdong 518129 (CN); LI, Yong, Shenzhen Guangdong 518129 (CN)
(74) Representative: Gill Jennings & Every LLP
(86) International application number: PCT/CN2016/101966
(87) International publication number: WO 2017/084457

(56) References cited:
- CN-A- 1 346 168
- CN-A- 104 577 728
- CN-A- 105 356 304
- CN-U- 204 391 499
- CN-Y- 201 307 727
- US-A- 3 949 277
- US-A1- 2009 116 174

## Description

### TECHNICAL FIELD

The present invention relates to the field of power electronics technologies, and in particular, to an output power distribution module and a power distribution cabinet.

### BACKGROUND

With continuous development of power electronics technologies, there are more types of power distribution devices, and functions of the power distribution devices are increasingly improved.

At present, various power distribution components inside a power distribution device are all installed in a mechanical part of a cabinet body. The cabinet body and the power distribution components are connected together by using cables, such as a vertical main busbar that provides a main shunt function for an output power distribution module, and a module interconnection busbar. A branch busbar is disposed in the output power distribution module and is connected to the main busbar by means of plug-in connection or the like, to implement internal connection of the entire cabinet.

The prior art has the following disadvantages:A copper bar design in an existing power distribution cabinet causes a complex internal structure of the power distribution cabinet, time-consuming assembling, and low efficiency. In addition, a large quantity of copper bars are used, and costs are high.

US 2009/116174 discloses a switchgear cabinet assembly or rack assembly, comprising busbar sections attached to the rear of sub-distribution units.

### SUMMARY

To resolve prior-art problems, embodiments of the present invention provide an output power distribution module and a power distribution cabinet.

According to the invention, an output power distribution module is provided. The output power distribution module includes a first power distribution control module and a second power distribution control module arranged symmetrically on opposite sides of the output power distribution module with an intermediate framework position between, where a power board, a monitor board, an output circuit breaker, and a customer wiring terminal are integrated inside both power distribution control modules; input copper bars are integrated on the intermediate framework; the input copper bars are connected to the power board, the monitor board, and the output circuit breaker of both power distribution modules by using a cable; the input copper bars are configured to bear a current inside a power distribution cabinet, and transmit an output value of the current to an adjacent output power distribution module; and the input copper bars are further configured to distribute, by using the cable, an input current to the power board, the monitor board, and the output circuit breaker of the power distribution modules, and the output circuit breakers output an input current to the customer wiring terminals. The input copper bars are integrated to the output power distribution module, thereby reducing a quantity of used copper bars inside the power distribution cabinet and reducing costs.

In a first possible implementation of the first aspect of the present invention, output ends of the input copper bars are connected, by means of bonding, to input ends of input copper bars that are integrated to the adjacent output power distribution module. Input copper bars of two adjacent output power distribution modules are connected by means of bonding, thereby simplifying an assembling process and improving assembling efficiency.

In a second possible implementation of the first aspect of the present invention, the bonding is implemented by plug-in connection of terminals. Bonding of input copper bars between modules is implemented by means of plug-in connection of terminals, thereby reducing time consumption of assembling and improving assembling efficiency.

In a third possible implementation of the first aspect of the present invention, the bonding is implemented by fastening a screw. Bonding of input copper bars between modules is implemented by fastening a screw, thereby reducing assembling complexity on a basis of ensuring installation stability.

In the third possible implementation of the first aspect of the present invention, input ends of the input copper bars are in a bending structure, and output ends of the input copper bars are in a vertical structure. The input ends of the input copper bars are designed as the bending structure. Therefore, on a basis of ensuring that space occupied by the input copper bars does not increase, an output end of a previous module can be connected to the output power distribution module by means of bonding.

According to another aspect, a power distribution cabinet is provided. The power distribution cabinet includes a cabinet body, an input module, and at least one output power distribution module according to the invention, where the at least one output power distribution module forms a series path by means of bonding between input copper bars, so that a current that is input by the input module is connected from the first output power distribution module in the at least one output power distribution module to the last output power distribution module in the at least one output power distribution module; and the input copper bars integrated inside each output power distribution module are further configured to supply power to a customer wiring terminal of each output power distribution module.

The technical solutions provided in the embodiments of the present invention bring the following beneficial effect:

Input copper bars are integrated to an output power distribution module, thereby reducing a quantity of used copper bars, reducing costs, simplifying assembling steps, and improving assembling efficiency.

### BRIEF DESCRIPTION OF DRAWINGS

To describe the technical solutions in the embodiments of the present invention more clearly, the following briefly describes the accompanying drawings required for describing the embodiments. Apparently, the accompanying drawings in the following description show merely some embodiments of the present invention, and a person of ordinary skill in the art may still derive other drawings from these accompanying drawings without creative efforts.
FIG. 1A is a view of an output power distribution module according to an embodiment of the present invention;
FIG. 1B is another view of an output power distribution module according to an embodiment of the present invention; to an embodiment of the present invention; and
FIG. 3 is a schematic diagram of bonding of input copper bars in a power distribution cabinet according to an embodiment of the present invention.

### DESCRIPTION OF EMBODIMENTS

To make the objectives, technical solutions, and advantages of the present invention clearer, the following further describes the embodiments of the present invention in detail with reference to the accompanying drawings.

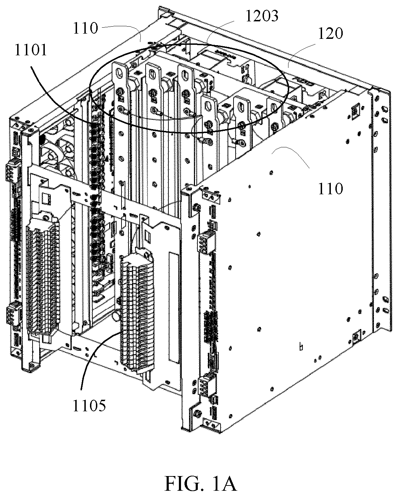

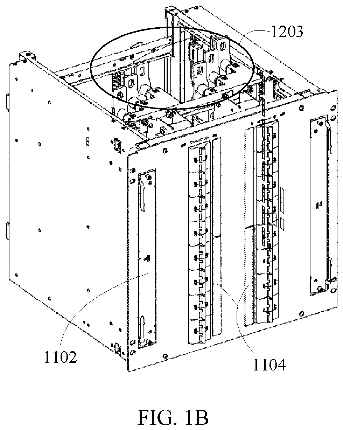

FIG. 1A is a view of an output power distribution module according to an embodiment of the present invention. To better describe an entire structure of the output power distribution module, an embodiment of the present invention further provides another view of the output power distribution module, as shown in FIG. IB. With reference to FIG. 1A and FIG. 1B, it can be known that the output power distribution module includes two power distribution control modules 110 and an intermediate framework 120.

A power board 1101, a monitor board 1102, an output circuit breaker 1104, and a customer wiring terminal 1105 are integrated inside each power distribution control module 110. Input copper bars 1203 are integrated on the intermediate framework 120. The customer wiring terminal 1105 serves as a power supply port for a user to use. The output circuit breaker 1104 is configured to implement electrical isolation. The output circuit breaker 1104 and the customer wiring terminal 1105 are connected by using a cable. The input copper bars 1203 are connected to the power board 1101, the monitor board 1102, and the output circuit breaker 1104 by using a cable. The input copper bars 1203 are configured to bear a current inside a power distribution cabinet, and transmit an output value of the current to a next output power distribution module. The input copper bars 1203 are further configured to distribute, by using the cable, an input current to the power board 1101, the monitor board 1102, and the output circuit breaker 1104, and the output circuit breaker 1104 outputs an input current to the customer wiring terminal 1105.

The power distribution control module 110 may be divided into a left-side module and a right-side module. The left-side module and the right-side module are in a left-right symmetric structure. A power board, a monitor board, an output circuit breaker, and a customer wiring terminal are integrated in each of the left-side module and the right-side module.

It should be noted that, according to the output power distribution module provided in this disclosed embodiment, a copper bar that provides a main shunt function for the output power distribution module is integrated inside the output power distribution module, so that the output power distribution module has a current conduction function of the output power distribution module, and when the output power distribution module is assembled in a power distribution cabinet, can conduct, by using input copper bars 1203, a current in an input module in the power distribution cabinet to an output power distribution module connected to the input module. An output end of the output power distribution module may be further connected to an output power distribution module that has a same structure as the output power distribution module. After input copper bars in each output power distribution module are connected, a current conduction function among all modules in the power distribution cabinet can be implemented.

In a structure of the foregoing output power distribution module, the input copper bars 1203 and the output power distribution module are integrated to form an entirety, thereby reducing a quantity of used copper bars and simplifying assembling steps.

In a possible implementation of this embodiment of the present invention, input ends of the input copper bars 1203 are in a bending structure, and output ends of the input copper bars 1203 are in a vertical structure. It can be known from FIG. 1A that the input ends of the input copper bars 1203 are in the bending structure, and the output ends are in the vertical structure, so that the output power distribution module can implement automatic bonding with another output power distribution module. As shown in FIG. 1A, flat cables included in each group of input copper bars in the input copper bars 1203 may be arranged in a step shape, or may be arranged on a same horizontal line. This embodiment of the present invention does not impose a limitation herein.

The output ends of the input copper bars 1203 are connected, by means of bonding, to input ends of input copper bars 1203 that are integrated to the next output power distribution module. An implementation method of the bonding may be implemented by plug-in connection of terminals, or may be implemented by fastening a screw. Certainly, the bonding may also be implemented by using another method.

It should be noted that a guide rail may be further installed at the bottom or on a side of the output power distribution module so that the output power distribution module can be put into a power distribution cabinet or removed from a power distribution cabinet. This does not impose a limitation on a specific structure of the guide rail or a location of the guide rail in the output power distribution module.

In an example, an assembling process of the output power distribution module may be: installing input copper bars 1203 on an intermediate framework 120, and separately connecting, by using a cable, input ends and output ends of the input copper bars 1203 to the intermediate framework 120; installing power boards in corresponding locations of a left-side module and a right-side module of a power distribution control module 110, and connecting, by using a cable, the power boards 1101 to miniature circuit breakers; and installing the left-side module and the right-side module of the power distribution control module 110 on the intermediate framework 120, where the miniature circuit breakers are configured to control connectivity of a current of a customer wiring terminal in the output power distribution module.

In another example, a manner of connecting the left-side module and the right-side module of the power distribution control module 110 to the intermediate framework 120 may be a foolproof mounting manner. In this connection manner, a mistake is avoided when the intermediate framework 120 is connected to the left-side module and the right-side module, thereby ensuring installation accuracy.

For the foregoing installation manner, provided that an installation result is not affected, some installation steps may also be adaptively adjusted.

According to the output power distribution module the present invention, input copper bars are integrated to the output power distribution module, thereby reducing a quantity of used copper bars, reducing costs, simplifying assembling steps, and improving assembling efficiency. In addition, copper bars between output power distribution modules and between an output power distribution module and an input module are connected by means of bonding, thereby implementing current conduction between the modules.

It should be noted that the output power distribution module may be applied to a low-voltage power distribution cabinet, or may be applied to a high-voltage power distribution cabinet.

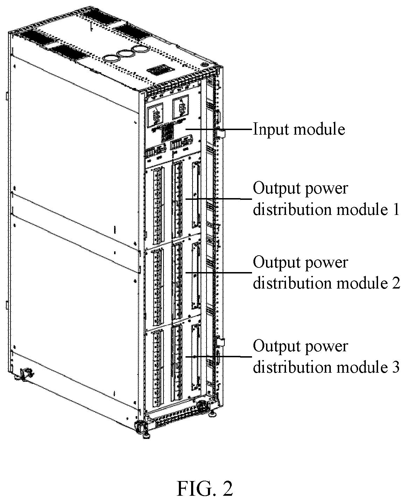

FIG. 2 is a schematic structural diagram of a power distribution cabinet according to an embodiment of the present invention. The power distribution cabinet includes a cabinet body, an input module, and at least one output power distribution module. Input copper bars are integrated inside each of the at least one output power distribution module. The at least one output power distribution module forms a series path by means of bonding between input copper bars, so that a current that is input by the input module is connected from the first output power distribution module in the at least one output power distribution module to the last output power distribution module in the at least one output power distribution module. The input copper bars integrated inside each output power distribution module are further configured to supply power to a customer wiring terminal of each output power distribution module.

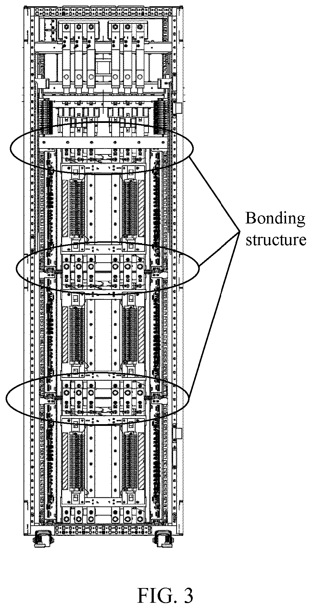

Using FIG. 2 as an example, FIG. 2 shows a power distribution cabinet assembled with three output power distribution modules. An input module and an output power distribution module 1 in the power distribution cabinet are vertically connected by means of bonding of copper bars. All output power distribution power modules are vertically connected by means of bonding of input copper bars, thereby forming a series path. A current in the input module sequentially flows, from top to bottom, into the three output power distribution modules by means of conduction by the input copper bars integrated inside the multiple output power distribution modules. FIG. 3 shows a bonding structure formed by sequential bonding of the input copper bars in the modules in the power distribution cabinet.

It should be noted that a method for installing the output power distribution modules in the power distribution cabinet may be: assembling the output power distribution modules in a plug-in manner by using a guide rail or a slot on the power distribution cabinet. If an output power distribution module in the power distribution cabinet becomes faulty, the output power distribution module may be independently removed, and the output power distribution module is replaced or repaired, without a need of disassembling the entire power distribution cabinet, thereby improving repair efficiency. Certainly, the output power distribution modules may also be installed in another manner in which the output power distribution modules can be easily inserted and removed. This example does not impose a limitation herein.

It should be noted that, according to the output power distribution module and the power distribution cabinet provided in the foregoing examples, division of the foregoing functional modules is used as an example for description. In an actual application, the foregoing functions may be completed by different functional modules as required, that is, internal structures of the output power distribution module and the power distribution cabinet are divided into different functional modules to implement all or some of the functions described above.

## Claims

1. An output power distribution module, comprising a first power distribution control module (110) and a second power distribution control module (110) arranged symmetrically on opposite sides of the output power distribution module with an intermediate framework (120) positioned between, wherein
a power board (1101), a monitor board (1102), an output circuit breaker (1104), and a customer wiring terminal (1105) are integrated inside each power distribution control module (110);
input copper bars (1203) are integrated on the intermediate framework (120) inside the power distribution module; the input copper bars (1203) are connected to the power board (1101), the monitor board (1102), and the output circuit breaker (1104) of the power distribution control modules by using a cable;
the input copper bars (1203) are configured to bear a current inside a power distribution cabinet, and transmit an output value of the current to an adjacent output power distribution module; and the input copper bars (1203) are further configured to distribute, by using the cable, an input current to the power board (1101), the monitor board (1102), and the output circuit breaker (1104) of the power distribution control modules, and the output circuit breaker (1104) of each power distribution control module (110) is configured to output an input current to the customer wiring terminal (1105).

2. The power distribution module according to claim 1, wherein output ends of the input copper bars (1203) are configured to be connected, by means of bonding, to input ends of input copper bars (1203) that are integrated to the adjacent output power distribution module (110).

3. The power distribution module according to claim 2, wherein the bonding is implemented by plug-in connection of terminals.

4. The power distribution module according to claim 2, wherein the bonding is implemented by fastening a screw.

5. The power distribution module according to claim 1, wherein input ends of the input copper bars (1203) are in a bending structure, and output ends of the input copper bars (1203) are in a vertical structure.

6. A power distribution cabinet, comprising a cabinet body, an input module, and at least two output power distribution modules according to any preceding claim, wherein the at least two output power distribution modules form a series path by means of bonding between the respective input copper bars (1203), so that a current that is input by the input module is connected from one of the output power distribution modules to the other output power distribution module and the input copper bars (1203) integrated inside each output power distribution module are further configured to supply power to a customer wiring terminal of each output power distribution module.

## Patentansprüche

1. Ausgangs-Leistungsverteilungsmodul, das ein erstes Leistungsverteilungs-Steuermodul (110) und ein zweites Leistungsverteilungs-Steuermodul (110) umfasst, die symmetrisch auf gegenüberliegenden Seiten des Ausgangs-Leistungsverteilungsmoduls mit einem dazwischen positionierten Zwischenrahmen (120) angeordnet sind, wobei
eine Leistungs-Platine (1101), eine Überwachungs-Platine (1102), ein Ausgangs-Trennschalter (1104) und ein Kunden-Verdrahtungsanschluss (1105) in jedem Leistungsverteilungs-Steuermodul (110) integriert sind;
Eingangs-Kupferschienen (1203) in dem Leistungsverteilungsmodul auf den Zwischenrahmen (120) integriert sind;
die Eingangs-Kupferschienen (1203) durch Verwendung eines Kabels mit der Leistungs-Platine (1101), der Überwachungs-Platine (1102) und dem Ausgangs-Trennschalter (1104) der Leistungsverteilungs-Steuermodule verbunden sind;
die Eingangs-Kupferschienen (1203) ausgelegt sind zum Führen eines Stroms in einen Leistungsverteilungsschrank und einen Ausgangswert des Stroms zu einem angrenzenden Ausgangs-Leistungsverteilungsmodul übertragen; und
die Eingangs-Kupferschienen (1203) ferner ausgelegt sind zum Verteilen eines Eingangsstroms an die Leistungs-Platine (1101), die Überwachungs-Platine (1102) und den Ausgangs-Trennschalter (1104) der Leistungsverteilungs-Steuermodule durch Verwendung des Kabels und der Ausgangs-Trennschalter (1104) jedes Stromverteilungs-Steuermoduls (110) ausgelegt ist zum Ausgeben eines Eingangsstroms an den Kunden-Verdrahtungsanschluss (1105).

2. Leistungsverteilungsmodul nach Anspruch 1, wobei Ausgangsenden der Eingangs-Kupferschienen (1203) dafür ausgelegt sind, mittels Bondung mit Eingangsenden von Eingangs-Kupferschienen (1203), die an das angrenzende Ausgangs-Leistungsverteilungsmodul (110) integriert sind, verbunden zu werden.

3. Leistungsverteilungsmodul nach Anspruch 2, wobei die Bondung durch Einsteckverbindung von Anschlüssen implementiert wird.

4. Leistungsverteilungsmodul nach Anspruch 2, wobei die Bondung durch Anziehen einer Schraube implementiert wird.

5. Leistungsverteilungsmodul nach Anspruch 1, wobei sich Eingangsenden der Eingangs-Kupferschienen (1203) in einer Biegestruktur befinden und sich Ausgangsenden der Eingangs-Kupferschienen (1203) in einer vertikalen Struktur befinden.

6. Leistungsverteilungsschrank, der einen Schrankkörper, ein Eingangsmodul und mindestens zwei Ausgangs-Leistungsverteilungsmodule nach einem der vorhergehenden Ansprüche umfasst, wobei die mindestens zwei Ausgangs-Leistungsverteilungsmodule mittels Bondung zwischen den jeweiligen Eingangs-Kupferschienen (1203) einen Reihenpfad bilden, so dass ein Strom, der durch das Eingangsmodul eingegeben wird, von einem der Ausgangs-Leistungsverteilungsmodule mit dem anderen Ausgangs-Leistungsverteilungsmodul verbunden wird und die in jedem Ausgangs-Leistungsverteilungsmodul integrierten Eingangs-Kupferschienen (1203) ferner dafür ausgelegt sind, einen Kunden-Verdrahtungsanschluss jedes Ausgangs-Leistungsverteilungsmoduls mit Leistung zu versorgen.

## Revendications

1. Module de distribution de puissance de sortie, comprenant un premier module de commande de distribution de puissance (110) et un second module de commande de distribution de puissance (110) agencés symétriquement sur des côtés opposés du module de distribution de puissance de sortie avec un cadre intermédiaire (120) positionné entre eux, dans lequel
un tableau de puissance (1101), un tableau de surveillance (1102), un disjoncteur de sortie (1104), et une borne de câblage client (1105) sont intégrés à l'intérieur de chaque module de commande de distribution de puissance (110) ;
des barres de cuivre d'entrée (1203) sont intégrées sur le cadre intermédiaire (120) à l'intérieur du module de distribution de puissance ;
les barres de cuivre d'entrée (1203) sont connectées au tableau de puissance (1101), au tableau de surveillance (1102), et au disjoncteur de sortie (1104) des modules de commande de distribution de puissance en utilisant un câble ;
les barres de cuivre d'entrée (1203) sont configurées pour supporter un courant à l'intérieur d'une armoire de distribution de puissance, et transmettre une valeur de sortie du courant à un module de distribution de puissance de sortie adjacent ; et
les barres de cuivre d'entrée (1203) sont en outre configurées pour distribuer, en utilisant le câble, un courant d'entrée au tableau de puissance (1101), au tableau de surveillance (1102), et au disjoncteur de sortie (1104) des modules de commande de distribution de puissance, et le disjoncteur de sortie (1104) de chaque module de commande de distribution de puissance (110) est configuré pour délivrer un courant d'entrée à la borne de câblage client (1105).

2. Module de distribution de puissance selon la revendication 1, dans lequel des extrémités de sortie des barres de cuivre d'entrée (1203) sont configurées pour être connectées, au moyen d'une attache, à des extrémités d'entrée de barres de cuivre d'entrée (1203) qui sont intégrées dans le module de distribution de puissance de sortie adjacent (110).

3. Module de distribution de puissance selon la revendication 2, dans lequel l'attache est mise en œuvre par connexion enfichable de bornes.

4. Module de distribution de puissance selon la revendication 2, dans lequel l'attache est mise en œuvre en vissant une vis.

5. Module de distribution de puissance selon la revendication 1, dans lequel des extrémités d'entrée des barres de cuivre d'entrée (1203) sont en une structure courbe, et des extrémités de sortie des barres de cuivre d'entrée (1203) sont en une structure verticale.

6. Armoire de distribution de puissance, comprenant un corps d'armoire, un module d'entrée, et au moins deux modules de distribution de puissance de sortie selon une quelconque revendication précédente, dans laquelle
les au moins deux modules de distribution de puissance de sortie forment un chemin en série au moyen d'une attache entre les barres de cuivre d'entrée respectives (1203), de sorte qu'un courant qui est entré par le module d'entrée soit connecté d'un des modules de distribution de puissance de sortie à l'autre module de distribution de puissance de sortie, et
les barres de cuivre d'entrée (1203) intégrées à l'intérieur de chaque module de distribution de puissance de sortie sont en outre configurées pour fournir une puissance à une borne de câblage client de chaque module de distribution de puissance de sortie.
